# EUROPÄISCHE PATENTANMELDUNG

(11) **EP 1 069 604 A2**
(43) Veröffentlichungstag der Anmeldung: **17.01.2001**
(21) Anmeldenummer: 00114756.0
(22) Anmeldetag: 10.07.2000
(51) Int. Cl.: H01L 21/311

(54) **Verfahren zum Ätzen von Schichten auf einem Halbleitersubstrat**

(30) Priorität: 15.07.1999 AT 123399
(71) Anmelder: SEZ Semiconductor-Equipment Zubehör für die Halbleiterfertigung AG, 9500 Villach (AT); Infineon Technologies AG, 81541 München (DE)
(72) Erfinder: Kruwinus, Hans-Jürgen, 9551 Bodensdorf (AT); de Nijs, Geert, 81545 München (DE)

(57) **Zusammenfassung**

Die Erfindung betrifft ein Verfahren zum Behandeln von Halbleitersubstraten, bei dem Metallschichten freigelegt werden, durch Entfernen einer oder mehreren auf der Metallschicht aufgebrachten Schicht bzw. Schichten einer Oberfläche eines Halbleitersubstrates vorgeschlagen, bei dem das Freilegen in zeitlicher Abfolge zu einem ersten Teil der Schicht durch einen Trockenätzschritt und zu einem zweiten Teil der Schicht durch einen Naßätzschritt erfolgt.

## Beschreibung

Die Erfindung betrifft ein Verfahren zum Behandeln von Halbleitersubstraten, bei dem Metallflächen freigelegt werden.

Die Metallflächen können Kontaktflächen (bonding pad, contacting pad) sein, die sich auf der Oberfläche von Halbleiter-Chips befinden. Solche Kontaktflachen dienen bei der Produktion von Integrierten Schaltkreisen der Verbindung mit Drähten (z.B. feine Golddrähte), welche wiederum mit dem äußeren Schaltkreis oder anderen elektronischen bzw. elektrischen Bauelementen verbunden sind.

Diese Kontaktflächen werden im sogenannten "back-end" Bereich der Halbleiterfertigung hergestellt.

Die Metallflächen (Metallschichten), die die Kontaktflächen des Halbleiter-Chips darstellen sollen, werden wie auch die restliche Oberfläche des Chips mit einer Passivierungsschicht überzogen. Diese Passivierungsschicht dient der Isolierung und dem Schutz der Halbleiterstrukturen vor Verunreinigungen, Feuchtigkeit, mechanischer Zerstörung und anderen Umwelteinflüssen wie z.B. Teilchenstrahlung.

Diese Passivierungsschicht (passivation layer) besteht im einfachsten Fall aus einer Schicht, üblicherweise Siliziumdioxid oder Siliziumnitrid. Üblich ist ein zweischichtiger Aufbau, wobei die der Metallschicht zugewandte, als erstes aufgebrachte Schicht dann meist Siliziumdioxid ist und die zweite Schicht meist Siliziumnitrid. Über diesen beiden Schichten kann noch eine weitere Schicht als Teil der Passivierungsschicht aufgebracht werden, z.B. eine Polyimid-Schicht, welche als zusätzliche Schutzschicht insbesondere vor Teilchenstrahlung aus der Umgebung dient.

Oft wird auch zwischen einer ersten auf der Metallschicht befindlichen Schicht (Dicke 0,3 - 3 µm, US 5,911,887), die dann als Isolator bzw. dielektrischen Schicht (dielectric layer) bezeichnet wird, und einer zweiten auf der dielektrischen Schicht befindlichen Schicht (Dicke 0,3 - 3 µm, US 5,911,887), die dann als eigentliche Passivierungsschicht bezeichnet wird, unterschieden.

Zwischen der Metallschicht und der Passivierungsschicht respektive der dielektrischen Schicht kann auch eine sogenannte Antireflexschicht (anti-reflex cap or coating, ARC) in einer Dicke von 5 - 250 nm aufgebracht worden sein (US 5,911,887). Diese Schicht dient dazu die Belichtung bei einer photolithographischen Behandlung zu ermöglichen bzw. zu erleichtern. Diese Antireflexschicht kann aus z.B. Titan, Titannitrid oder Titan-Wolfram bestehen.

Zusätzlich kann zwischen der Metallschicht und der Antireflexschicht respektive der Passivierungsschicht auch eine sogenannte Ätzstopschicht (etch stop layer) in einer Dicke von 5 - 250 nm aufgebracht worden sein (US 5,911,887). Diese Schicht dient dazu bei Erreichen dieser Schicht die Ätzgeschwindigkeit (Ätzrate) stark zu senken, damit die darunter liegende Metallschicht nicht angegriffen wird. Die Ätzstopschicht kann gleichzeitig die Aufgabe einer Antireflexschicht übernehmen.

Weiters kann zwischen der Metallschicht und der Passivierungsschicht bzw. wenn vorhanden der Antireflexschicht und der Passivierungsschicht eine so genannte Diffusions-Barriere-Schicht (diffusion barrier layer, US 5,756,376) aufgebracht sein.

Zum Strukturieren bzw. Freilegen der Kontaktflächen bzw. Metallschichten wird auf der obersten der oben erwähnten Schichten ein Photolack (Photoresist) aufgebracht, der nach dem Belichten, Entwickeln und Härten als Ätzmaske dient. Wird als oberste Schicht z.B. ein lichtempfindliches Polyimid verwendet, so behält dieses nach dem Freilegen der Metallschichten die Aufgabe einer zusätzlichen Passivierungsschicht und braucht nicht entfernt zu werden.

Die Kontaktflächen können eine Große von z.B. 100 x 100 µm haben mit einem Abstand zu einander von 50 bis 100 µm (US 5,433,823).

In der US 5,433,823 wird erwähnt, daß Flächen dieser Größenordnung naß geätzt werden können, jedoch ist eine Trockenätzung bevorzugt. Der Grund für die Bevorzugung des Trockenätzens ist, daß derart dicke Schichten (bis über 1 µm) entweder nur langsam mit hohem Chemikalienverbrauch oder mit sehr aggressiven Ätzlösungen entfernt werden können. Außerdem besteht die Gefahr, daß unter den Photoresist (gehärteter Photolack) geätzt wird. Wie eine Naßätzung zum Freilegen der Kontaktflächen erfolgen könnte, wird in der US 5,433,823 aber nicht erwähnt. Es wird ein Trockenätzverfahren für die Passivierungsschicht (hier Siliziumnitrid auf Siliziumdioxid) beschrieben, das eine hohe Selektivität gegen den Photoresist (gehärteter Photolack) und gegen die Diffusiuns-Barriere-Schicht bzw. Antireflexschicht (hier Titan-Wolfram) haben soll.

In der US 5,824,234 wird ein Verfahren zum Herstellen von Kontaktflächen beschrieben, wobei das Ätzen der über der Metallfläche befindlichen Schichten zum Freilegen der Metallflächen mit Hilfe eines fluorhältigen Gases durch reaktives Ionenätzen oder Plasmaätzen erfolgt. Die dadurch entstehenden Fluor enthaltenden Schichten stellen eine unerwünschte Verunreinigung dar, da diese den ohmschen Widerstand des Kontaktes erhöhen. Diese Verunreinigungen können einerseits fluorhältige Polymere und andererseits Metallfluoride (z.B. AlF₃) sein. Das Reinigen der Kontaktflächen bzw. das Entfernen der Verunreinigungen erfolgt durch Eintauchen der Halbleiterscheiben (Wafer) in eine Reinigungslösung. Die Reinigungslösung ist eine wässrige, basische Lösung - sie enthält z.B. Tetra-Methyl-Ammonium-Hydroxid (TMAH).

Die US 5,911,887 schlägt verschiedene Aufbauten der Schichten über der Kontaktfläche vor, und es wird eine Ätzstopschicht, die gleichzeitig Antireflexschicht sein kann, angeboten. Die Passivierungsschicht und die dielektrische Schicht werden in einem ersten Trockenätzschritt (Plasmaätzen oder reaktives Ionenätzen) entfernt. Dieser Ätzschritt, der die Ätzstopschicht kaum angreift, wird mit fluorhältigen Ätzgasen (z.B. C₂F₆, und/oder CHF₃) durchgeführt. In einem zweiten Ätzschritt wird die Ätzstopschicht entfernt und so die Metallschicht freigelegt. Dieser zweite Ätzschritt ist ebenfalls ein Trockenätzschritt, der zur Vermeidung der Bildung von Polymeren keine kohlenstoffhältigen Gase verwenden soll. Als Beispiele sind unter anderem Cl₂, HCl oder SF₆ angeführt.

Auch wenn sich keine Polymere auf der Metalloberfläche bilden, so bilden sich bei Verwendung von fluorhältigen Gasen zumindest die in der US 5,824,234 beschriebenen Metallfluoride (z.B. AlF₃) bzw. bei Verwendung von chlorhältigen Gasen ein Metallchloride (z.B. AlCl₃). Diese Metallhalogenide müssen anschließend entfernt oder umgewandelt werden.

In US 5,731,243 wird beschrieben, daß die, nach dem Freilegen der Metallschicht der Kontaktfläche in der Nähe der Kontaktflächen verbleibenden Polymere naßchemisch entfernt werden. Die verwendeten Lösungen enthalten z.B. Dimethylsulfoxid und Monoethanolamin. Dieser Schritt erfolgt hier vor dem Dünnschleifen der Halbleiterscheibe (des Wafers), während dem die Oberfläche der Halbleiterscheibe auf der sich die Strukturen befinden mit Hilfe einer selbstklebenden Folie geschützt wird. Das Entfernen der Polymere vor dem Dünnschleifen soll verhindern, daß Reste der Folie an den Polymeren haften bleiben und so die Kontaktflächen stark verunreinigen.

Die Nachteile der oben beschriebenen Verunreinigungen auf Kontaktflächen können sein: ein hoher ohmscher Widerstand des Kontaktes mit einem Draht, eine schlechte Haftfestigkeit eines Drahtes auf der Kontaktfläche oder fehlender Kontakt mit Kontaktelementen eines Prüfmittels während des Prüfens. Im letzteren Fall kann es dazu führen, daß ein eigentlich funktionsfähiger Halbleiterchip als schlecht aussortiert wird, nur weil die Kontaktflächen verunreinigt sind.

Aufgabe der Erfindung war es, ein vereinfachtes, verkürztes Verfahren zum Freilegen einer Metallschicht anzubieten, nach dem gleichzeitig die Kontaktflächen frei von Verunreinigungen sind.

Erfindungsgemäß wird ein Verfahren zum zumindest teilweisen Freilegen einer Metallschicht durch Entfernen einer oder mehreren auf der Metallschicht aufgebrachten Schicht bzw. Schichten einer Oberfläche eines Halbleitersubstrates vorgeschlagen, bei dem das Freilegen in zeitlicher Abfolge zu einem ersten Teil der Schicht durch einen Trockenätzschritt und zu einem zweiten Teil der Schicht durch einen Naßätzschritt erfolgt.

Dadurch können sich die beim Trockenätzschritt entstehenden Nebenprodukte nicht direkt auf der Metallschicht ablagern. Vielmehr lagern sie sich zumindest teilweise auf dem nach dem Ende des Trockenätzschrittes noch nicht entfernten zweiten Teil der Schicht ab. Dieser zweite Teil wird nun durch einen Naßätzschritt entfernt, wodurch gleichzeitig die Nebenprodukte bzw. Rückstände des Trockenätzschrittes mit entfernt werden.

Zwischen den beiden Ätzschritten können auch andere Verfahrensschritte durchgeführt werden. Der verbleibende Teil der Schicht übernimmt so während der anderen Verfahrensschritte die Funktion einer Schutzschicht.

Der mit dem Trockenätzschritt abgetragene erste Teil der Schicht kann mehr als 80 % bzw. sogar mehr als 90 % der ursprünglich aufgebrachten Schicht betragen. Dadurch, daß dieser Schritt mit üblicherweise schnellen Trockenätzverfahren durchgeführt wird, kann der gesamte Abtrag (das Entfernen der über der Metallschicht aufgebrachten Schicht) wirtschaftlich gehalten werden.

Der in diesem Fall kleinere zweite Teil der Schicht kann dann mit einem langsamen Naßätzverfahren entfernt werden, da nur mehr wenig abgetragen werden muß. Oder er erfolgt mit einem schnellen Naßätzverfahren, da auf Grund der nur mehr geringen verbleibenden Schichtdicke die sonst nur schwer erreichbare Gleichmäßigkeit ein geringeres Problem darstellt.

Die freigelegten Metallschichten können jede Art von Kontaktflächen sein, d.h. für die Ausbildung von Kontaktlöchem (via holes) zwischen zwei Metallisierungsebenen oder auch Kontaktflächen, die der Verbindung des Halbleiters mit Drähten dienen (bonding pads).

Einen Vorteil bringt das erfindungsgemäße Verfahren, wenn die freizulegenden Metallschichten Kontaktflächen sind, die der Verbindung des Halbleiters mit Drähten dienen, da in diesem Fall relativ große Flächen freigelegt werden müssen.

Bei einer Ausführungsform des erfindungsgemäßen Verfahrens besteht der erste Teil der Schicht aus einem ersten Material und der zweite Teil der Schicht aus einem zweiten Material, und das erste Material unterscheidet sich vom zweiten Material.

Dadurch wird ermöglicht, daß der Trockenätzschritt im wesentlichen unmittelbar nach Entfernen des ersten Teils der Schicht gestoppt werden kann. Dies kann entweder durch ein Endpunkterkennungssystem erfolgen oder dadurch, daß die zweite Schicht durch den Trockenätzschritt kaum angegriffen wird.

Bei einer weiteren Ausführungsform des erfindungsgemäßen Verfahrens werden die Parameter des Trockenätzschrittes so gewählt, daß der erste Teil der Schicht stärker angegriffen wird als der zweite Teil der Schicht, wodurch sich die Ätzgeschwindigkeit verringert. Dies kann unter anderem durch Wahl einer geeigneten Temperatur, eines geeigneten Drucks oder einer geeigneten Zusammensetzung der Ätzgasmischung erfolgen.

Geeignete Verfahren für den Trockenätzschritt können aus der Gruppe Plasmaätzen, reaktives Ionenätzen, Elektronenstrahl-Ätzen gewählt werden. Als vorteilhaft hat sich ein Plasmaätzen gezeigt.

Nach einer Ausführungsform des Verfahrens ist im Ätzmedium des Trockenätzschrittes ein fluorhältiges Gas enthalten. Das ist insbesondere dann vorteilhaft, wenn der zu entfernende erste Teil der Schicht aus einem siliziumhältigen Nichtleiter besteht, wie zum Beispiel aus Siliziumdioxid und/oder Siliziumnitrid.

Nach einer weiteren Ausführungsform des Verfahrens ist im Ätzmedium des Trockenätzschrittes zusätzlich zum fluorhältigen Gas Sauerstoff enthalten. Das ist dann vorteilhaft, wenn der zu entfernende erste Teil der Schicht aus Siliziumnitrid besteht.

Werden die Parameter des Naßätzschrittes so gewählt, daß der zweite Teil der Schicht stärker angegriffen wird als der erste Teil der Schicht, so werden die nach dem Trockenätzen des ersten Teils der Schicht entstandenen übriggebliebenen Seitenwände des ersten Teils nicht durch die Flüssigkeit des Naßätzschrittes geätzt. Die einzustellenden Parameter können unter anderem Temperatur, Fließgeschwindigkeit und Konzentration der Komponenten sowie Wahl des Lösungsmittels der Ätzflüssigkeit sein.

Mögliche Naßätzverfahren stellen Tauchverfahren, Sprühätzverfahren sowie Rotationsätzverfahren oder eine Kombination dieser Verfahren dar. Unter einem Tauchverfahren versteht man ein Verfahren, bei dem eine oder eine Vielzahl von Halbleiterscheibe(n) vollständig in die Flüssigkeit getaucht werden, dabei kann die Flüssigkeit auch an den Oberflächen der Halbleiterscheibe(n) vorbeiströmen. Bei einem Sprühätzverfahren wird die Flüssigkeit auf die Oberflächen aufgesprüht, wobei die Halbleiterscheiben auch gleichzeitig rotieren können.

Unter einem Rotationsätzverfahren, auch Spin-Etch-Verfahren, versteht man ein Verfahren, bei dem die Ätzflüssigkeit auf zumindest eine Oberfläche der Halbleiterscheibe im kontinuierlichen Strom ohne Zerstäuben der Flüssigkeit aufgebracht wird, während diese rotiert und die Flüssigkeit über den umfangseitigen Rand der Halbleiterscheibe abgeschleudert wird.

Vorteilhaft ist ein Rotationsätzverfahren, bei dem die Halbleiterscheiben einzeln nach einander behandelt werden, wie es z.B. in der EP 0 444 714 B1 beschrieben wird.

In einer Ausführungsform des erfindungsgemäßen Verfahrens ist das Ätzmittel des Naßätzschrittes eine wässrige Lösung. Dies bringt unter anderem den Vorteil, daß die gebrauchte Ätzlösung leichter entsorgt werden kann.

Vorteilhafterweise enthält das Ätzmittel des Naßätzschrittes ein Oxidationsmittel, und zwar insbesondere dann, wenn der zu entfernende zweite Teil der Schicht ein Metall (z.B. Ti), eine Legierung (z.B. TiW) oder eine nicht oxidische Metallverbindung (z.B. TiN) enthält.

Gute Ergebnisse konnten mit einer sauren Lösung erzielt werden. Ein Ätzmittel, das Salpetersäure und Flußsäure enthält, zeigte sich als vorteilhaft, wobei gut reproduzierbare Ergebnisse erzielt werden, wenn das Molverhältnis von HNO₃ : HF im Bereich von 3 : 1 bis 1000 : 1 liegt.

Auch gibt es gute Ergebnisse mit basischen Lösungen zum Entfernen des zweiten Teils der Schicht. Ein vorteilhaftes Ätzmittel enthält Ammoniak oder ein Amin und Wasserstoffperoxid.

Einen weiteren Teil der Erfindung stellt ein Verfahren zum Dünnen von Halbleiterscheiben dar, bei dem der Trockenätzschritt zum Entfernen eines ersten Teils einer Schicht zum Freilegen eines zweiten Teils einer Schicht vor dem Dünnen und der Naßätzschritt zum Entfernen eines zweiten Teils einer Schicht zum Freilegen einer Metallschicht nach dem Dünnen durchgeführt wird.

Das Dünnen erfolgt beispielsweise durch mechanisches Dünnschleifen der Rückseite, wobei unmittelbar vor dem Schleifen eine Folie auf die Oberfläche der Halbleiterscheibe, die die Strukturen trägt, zu deren Schutz aufgebracht wird. Unmittelbar nach dem Schleifen wird diese wieder entfernt. Anschließend wird die Oberfläche, von der die Folie entfernt wurde, dem Naßätzschritt unterzogen, wodurch ein zusätzlicher Reinigungsschritt zum Entfernen der Klebereste der Folie entfallen kann.

Weitere Einzelheiten der Erfindung ergeben sich aus dem folgenden Beispiel.

Auf der Oberfläche einer Silizum-Halbleiterscheibe, die die Strukturen trägt sollen Kontaktflächen (bonding pads), die später mit Gold-Drähten verbunden werden sollen, gebildet werden. Dazu werden in der folgender Reihenfolge die folgenden Schichten aufgebracht:
(1) eine 600 nm dicke Aluminiumschicht, die entsprechend der späteren Anordnung der Kontaktflächen strukturiert wird,
(2) eine 20 nm dicke Titanschicht als Antireflexschicht,
(3) eine 30 nm dicke Titannitridschicht als Diffusions-Barriere-Schicht,
(4) eine 300 nm dicke Silizumdioxidschicht mit Hilfe von Plasma als Teil der Passivierungsschicht,
(5) eine 500 nm dicke Siliziumnitridschicht mit Hilfe von Plasma als Teil der Passivierungsschicht,
(6) eine lichtempfindliche Polyimidschicht durch Aufschleudern (Spin-Coating), die entsprechend strukturiert wird, wobei die Bereiche über den späteren Kontaktflächen entfernt werden.

Nun erfolgt eine Plasma-Ätzbehandlung mit einem Gasgemisch aus Tetrafluorkohlenstoff und Sauerstoff wobei die Siliziumnitridschicht und die Silizumdioxidschicht entfernt werden. Bei Erreichen der Titannitridschicht verringert sich die Ätzgeschwindigkeit stark, und der Plasma-Ätzschritt wird beendet.

Anschließend wird die Oberfläche zum Entfernen des Titannitrids und des Titans mit einer wässrigen Lösung aus Salpetersäure (c = 10 mol/l) und Flußsäure (c = 3 mol/l) auf einem SEZ Spin-Processor 203 mit einer Rotationsgeschwindigkeit von 500 min⁻¹ behandelt (T = 25°C, Volumenstrom: 15 l/min). Die Rückseite wird während des Verfahrens mit Stickstoff gespült. Bei Freilegen der Aluminiumschicht, was durch ein Endpunkterkennungssystem angezeigt wird, wird der Auftrag der Ätzflüssigkeit gestoppt und unmittelbar nach dem Abschleudern der Ätzflüssigkeit mit deionisiertem Wasser gespült und getrocknet.

Durch eine leichte kontrollierte Überätzung kann die Aluminiumschicht gezielt konditioniert werden, wobei dies durch einen definierten Abtrag des Aluminiums (ca. 20 nm) erfolgt.

## Patentansprüche

1. Verfahren zum zumindest teilweisen Freilegen einer Metallschicht auf einer Oberfläche eines Halbleitersubstrates durch abtragendes Entfernen wenigstens einer auf der Metallschicht aufgebrachten Schicht dadurch gekennzeichnet, daß in zeitlicher Abfolge ein erster Teil der Schicht durch Trockenätzen und zu einem zweiten Teil der Schicht durch Naßätzen entfernt wird.

2. Verfahren nach Anspruch 1, dadurch gekennzeichnet, daß mit dem Trockenätzen mehr als 80 %, insbesondere mehr als 90 %, der Schicht entfernt werden.

3. Verfahren nach einem der Ansprüche 1 und 2, dadurch gekennzeichnet, daß die freizulegenden Metallschichten Kontaktflächen sind, die der Verbindung des Halbleitersubstrates mit Drähten dienen.

4. Verfahren nach einem der Ansprüche 1 bis 3, dadurch gekennzeichnet, daß der erste Teil der Schicht aus einem ersten Material und der zweite Teil der Schicht aus einem zweiten Material besteht und das erste Material sich vom zweiten Material unterscheidet.

5. Verfahren nach Anspruch 4, dadurch gekennzeichnet, daß der erste Teil der Schicht beim Trockenätzen stärker angegriffen wird als der zweite Teil der Schicht.

6. Verfahren nach Anspruch 5, dadurch gekennzeichnet, daß als Trockenätzen ein Plasmaätzen ausgeführt wird.

7. Verfahren nach einem der Ansprüche 4 und 5 dadurch gekennzeichnet, daß der zweite Teil der Schicht beim Naßätzen stärker angegriffen wird als der erste Teil der Schicht.

8. Verfahren nach einem der Ansprüche 1 bis 7, dadurch gekennzeichnet, daß das Naßätzen aus der Gruppe Tauchätzen, Sprühätzen, Rotationsätzen gewählt wird.

9. Verfahren nach Anspruch 8, dadurch gekennzeichnet, daß das Naßätzen ein Rotationsätzen ist, bei dem die Halbleitersubstrate einzeln nach einander behandelt werden.

10. Verfahren zum Dünnen von scheibenförmigen Halbleitersubstraten, bei dem ein Verfahren nach einem der Ansprüche 1 bis 9 verwendet wird, dadurch gekennzeichnet, daß das Trockenätzen vor dem Dünnen und das Naßätzen nach dem Dünnen durchgeführt wird.
